# EUROPÄISCHE PATENTSCHRIFT

(11) **EP 0 717 558 B1**
(45) Veröffentlichungstag und Bekanntmachung des Hinweises auf die Patenterteilung: **24.05.2000**
(21) Anmeldenummer: 95203363.7
(22) Anmeldetag: 06.12.1995
(51) Int. Cl.: H04N 5/20, H03G 7/06

(54) **Schaltungsanordnung zur amplitudenabhängigen Bedämpfung eines Fernsehsignals**
Circuit for the amplitude-dependent attenuation of a television signal
Circuit d'atténuation en fonction de l'amplitude pour un signal de télévision

(30) Priorität: 16.12.1994 DE 4444899
(43) Veröffentlichungstag der Anmeldung: 19.06.1996
(73) Patentinhaber: Philips Corporate Intellectual Property GmbH, 52064 Aachen (DE); Koninklijke Philips Electronics N.V., 5621 BA Eindhoven (NL)
(72) Erfinder: Peters, Matthias, c/o Philips Patentverwaltung, E-22335 Hamburg (DE)
(74) Vertreter: von Laue, Hanns-Ulrich, Dipl.-Ing.

(56) Entgegenhaltungen:
- EP-A- 0 414 159
- DE-A- 4 206 261
- US-A- 3 986 048

## Beschreibung

Die Erfindung betrifft eine Schaltungsanordnung zur amplitudenabhängigen Bedämpfung eines Fernsehsignals, welche Amplitudenwerte des Fernsehsignals unterhalb eines vorgebbaren Grenzwertes um einen ersten Verstärkungsfaktor verstärkt als Ausgangssignal liefert und welche bei Amplitudenwerten oberhalb des Grenzwertes den Amplitudenanteil unterhalb des Grenzwertes um den ersten Verstärkungsfaktor und Amplitudenanteile oberhalb des Grenzwertes um einen zweiten Verstärkungsfaktor verstärkt als Ausgangssignal liefert, wobei der zweite Verstärkungsfaktor kleiner gewählt ist als der erste.

Eine derartige Schaltungsanordnung wird z.B. in dem Fernseher ML 29-910 B der Fa. PHILIPS eingesetzt.

In der Fernsehtechnik tritt das Problem auf, daß sehr hohe Signalamplituden, welche bei sehr hellen Bilddetails auftreten, durch geeignete Schaltungen bedämpft werden müssen, um eine Unschärfe und ein Aufblühen des Leuchtschirmes bei großen Werten des Elektronenstrahlstromes zu verhindern. Hierfür gibt es zwei prinzipielle Möglichkeiten:
a) Die Signalamplitude wird bei Überschreiten eines vorgebbaren Grenzwertes auf einen festen Wert begrenzt. Dies bedingt jedoch, daß oberhalb des Grenzwertes keine Helligkeitsunterschiede übertragen werden und somit keine Konturenunterschiede mehr erkennbar sind.
b) Die Signalamplitude wird bei Überschreiten eines vorgebbaren Grenzwertes um einen vorgebbaren Faktor bedämpft. Dadurch werden auch oberhalb des Grenzwertes noch Helligkeitsunterschiede übertragen und scharfe Bilder erzeugt. Bisherige Realisierungen dieser Möglichkeit arbeiten im Spannungsbereich und sind extern außerhalb eines RGB-Prozessors angeordnet.

Aus der DE 42 06 261 A1 ist eine Luminanzkorrekturschaltung für ein Luminanzsignal bekannt, mittels derer verschiedene Formen von Korrekturkennlinien erzeugt werden können. Die Luminanzkorrekturschaltung umfaßt eine Schaltung, bei der der Strom bei einer ersten vorbestimmten Spannung oder darüber steigt und bei einer zweiten vorbestimmten Spannung oder darüber sinkt, so daß der Strom in einem vorbestimmten Bereich abgegeben wird. Eine derartige Kennlinie ist für die amplitudenabhängige Bedämpfung eines Fernsehsignals jedoch nicht geeignet. Darüber hinaus ist diese Luminanzkorrekturschaltung sehr aufwendig. Aus der DE 38 03 291 A1 ist eine sogenannte "Knieschaltung" bekannt, welche in einer Schaltung zur Weiß-Kompression eines Videosignals eingesetzt wird. In der DE 31 34 600 A1 ist eine Ansteuerschaltung für einen Regelverstärker mit Begrenzerkennlinie angegeben.

Aus der US 3,986,048 ist ein nichtlinearer Verstärker bekannt, bei dem das Eingangssignal als Stromsignal vorliegt.

Aus der EP 414159 A2 ist eine Verstärkeranordnung zur Erzeugung einer steuerbaren nichtlinearen Übertragungscharakteristik bekannt.

Es ist Aufgabe der Erfindung, eine Schaltungsanordnung der eingangs genannten Art zu schaffen, welche im Strombereich arbeitet, welcher also das Fernsehsignal als Strom zugeführt wird.

Diese Aufgabenstellung wird erfindungsgemäß dadurch gelöst, daß das Fernsehsignal als Stromsignal vorliegt, welches einem Haupt- und einem Nebenzweig zugeführt wird, in welchen es jeweils über einen Widerstand dem Emitter jeweils wenigstens eines Transistors zugeführt wird, daß jeweils die Basis beider Transistoren mittels Gleichspannungsquellen gegenüber einem Bezugspotential vorgespannt ist, daß der Kollektorstrom des Transistors im Hauptzweig im wesentlichen das Ausgangssignal darstellt und daß der Grenzwert mittels der Differenz der Basispotentiale beider Transistoren und der zweite Verstärkungsfaktor mittels des Verhältnisses der Widerstandswerte beider Widerstände vorgebbar ist.

Die grundlegende Funktion der Schaltungsanordnung besteht darin, einen Teil des Stromes bei Übersteigen des Grenzwertes vom Hauptzweig auf einen Nebenzweig abzuleiten und so eine Dämpfung des Stromes im Hauptzweig zu bewirken. Dies wird durch unterschiedliche Basisvorspannungen der Transistoren im Haupt- und Nebenzweig erreicht. Bei kleinen Amplituden ist der Transistor im Nebenzweig gesperrt und der gesamte Strom wird über den Hauptzweig geführt. Bei Überschreiten dieses Grenzwertes wird der Transistor des Nebenzweiges leitend und der Strom teilt sich entsprechend dem Verhältnis der Widerstandswerte der Widerstände in Haupt- und Nebenzweig auf.

Der Verstärkungsfaktor ist der Faktor, um den Amplitudenanteile, die oberhalb bzw. unterhalb des Grenzwertes liegen, verstärkt im Ausgangssignal zur Verfügung stehen. Er kann sowohl kleiner als 1 als auch größer als 1 sein. In der Regel wird er für Amplitudenwerte unterhalb des Grenzwertes nahezu 1 betragen und für Amplitudenwerte oberhalb des Grenzwertes einen Wert zwischen 0 und 1 aufweisen.

Die Realisierung der Schaltungsanordnung im Strombereich hat den Vorteil, daß sie eine Integration in einen RGB-Prozessor ermöglicht, dessen interne Schnittstellen im Strombereich liegen. Dadurch kann auf zusätzliche Strom-Spannungswandler bzw. Spannungs-Stromwandler verzichtet werden, welche zu unnötigen Leistungsverlusten führen und die Bandbreite verringern würden. Ferner ist für die Schaltungsanordnung kein zusätzlicher Strombedarf erforderlich, da bei Überschreiten des Grenzwertes lediglich ein Teil des Stromes auf den Nebenzweig umgeleitet wird, wobei sich der insgesamt in die Schaltungsanordnung eingespeiste Strom nicht ändert.

Gemäß einer vorteilhaften Ausgestaltung der Erfindung ist vorgesehen, daß das Basispotential des Transistors im Hauptzweig in Abhängigkeit des Kollektorstromes des Transistors des Nebenzweiges derart gesteuert wird, daß eine Erhöhung des Kollektorstromes des Transistors des Nebenzweiges das Basispotential des Transistors des Hauptzweiges derart ändert, daß der Kollektorstrom des Transistors des Hauptzweiges vermindert wird.

Da der Transistor im Nebenzweig bei Überschreiten des Grenzwertes nicht schlagartig leitend wird, tritt in der Umgebung des Grenzwertes ein Übergangsbereich auf. Der Übergangsbereich kann verengt werden, indem der Kollektorstrom des Transistors im Nebenzweig zur Steuerung des Basispotentials des Transistors im Hauptzweig herangezogen wird. Bei Verwendung beispielsweise von pnp-Transistoren ist die Schaltung so ausgelegt, daß der Kollektorstrom des Transistors im Nebenzweig das Basispotential des Transistors im Hauptzweig erhöht. Dadurch nimmt der Strom im Hauptzweig ab und der Strom im Nebenzweig steigt weiter an.

Gemäß einer weiteren vorteilhaften Ausgestaltung der Erfindung ist vorgesehen, daß das Basispotential des Transistors im Hauptzweig konstant gehalten wird und daß das Basispotential des Transistors im Nebenzweig bei Erhöhung des Kollektorstromes des Transistors im Nebenzweig derart verändert wird. daß dessen Kollektorstrom infolge der Basispotentialänderung weiter erhöht wird.

Der Vorteil des konstanten Basispotentials des Transistors im Hauptzweig liegt insbesondere darin, daß die Basis dieses Transistors wechselstrommäßig niederohmig mit dem Bezugspotential gekoppelt ist und sich so eine höhere Bandbreite erzielen läßt. Um einen schmalen Übergangsbereich zu verwirklichen, wird das Basispotential des Transistors im Nebenzweig von dessen eigenem Kollektorstrom gesteuert. Bei Verwendung von pnp- Transistoren beispielsweise ist die Schaltung so ausgelegt, daß der Kollektorstrom des Transistors im Nebenzweig dessen Basispotential erniedrigt und so eine Erhöhung des Kollektorstromes im Nebenzweig bewirkt (selbstverstärkender Effekt).

Gemäß einer weiteren vorteilhaften Ausgestaltung der Schaltungsanordnung, bei der das Basispotential des Transistors im Hauptzweig in Abhängigkeit des Kollektorstromes des Transistors im Nebenzweig gesteuert wird, ist vorgesehen, daß die Basis des Transistors des Hauptzweiges mit dem Kollektor des Transistors des Nebenzweiges gekoppelt ist und daß der Kollektor des Transistors des Nebenzweiges wechselstrommäßig über einen Widerstand mit dem Bezugspotential gekoppelt ist.

Sobald im Transistor des Nebenzweiges ein Kollektorstrom fließt, bewirkt der Stromfluß über den eingefügten Widerstand die gewünschte Potentialänderung an der Basis des Transistors im Hauptzweig. Durch diese Potentialänderung nimmt der Strom im Hauptzweig weiter ab, während der Strom im Nebenzweig weiter ansteigt.

Gemäß einer weiteren vorteilhaften Ausgestaltung dieser Schaltungsanordnung ist vorgesehen, daß der Kollektor des Transistors des Nebenzweiges mit dem Emitter eines dritten Transistors gekoppelt ist, dessen Kollektor mit Bezugspotential gekoppelt ist und daß die Basis des Transistors gegenüber dem Bezugspotential vorgespannt ist. Der eingefügte Widerstand hat im wesentlichen die Aufgabe, den Übergangsbereich zwischen den beiden Verstärkungsfaktoren zu verengen. Ist der endgültige Wert des zweiten Verstärkungsfaktors erreicht, ist die Funktion des eingefügten Widerstandes eigentlich überflüssig. Durch den dritten Transistor kann die Wirkung des eingefügten Widerstandes ab einem bestimmten Amplitudengrenzwert wieder aufgehoben werden, indem das Kollektorpotential des Transistors des Nebenzweiges wechselstrommäßig mit Bezugspotential gekoppelt wird. Der Amplitudengrenzwert läßt sich über die Basisvorspannung des dritten Transistors einstellen.

Gemäß einer weiteren vorteilhaften Ausgestaltung der Schaltungsanordnung, bei der das Basispotential des Transistors im Hauptzweig in Abhängigkeit des Kollektorstromes des Transistors im Nebenzweig gesteuert wird, ist vorgesehen, daß die Basis des Transistors des Hauptzweiges mit dem Kollektor des Transistors des Nebenzweiges gekoppelt ist und daß der Kollektor des Transistors des Nebenzweiges wechselstrommäßig über eine Diode mit dem Bezugspotential gekoppelt ist.

Der Eingangswiderstand des Nebenzweiges ergibt sich aus der Summe der Widerstandswerte des Emitterwiderstandes des Transistors des Nebenzweiges und des differentiellen Basis-Emitter-Widerstandes des Transistors des Nebenzweiges abzüglich des Widerstandswertes des eingefügten Widerstandes, der zur wechselstrommäßigen Kopplung des Kollektors des Transistors des Nebenzweiges mit dem Bezugspotential vorgesehen ist. Im Bereich des Grenzwertes ist der Kollektorstrom des Transistors des Nebenzweiges noch klein und dementsprechend der differentielle Basis-Emitterwiderstand sehr groß und dominierend gegenüber dem Emitterwiderstand. Wird anstelle des Widerstandes, der den Kollektor des Transistors des Nebenzweiges wechselstrommäßig mit dem Bezugspotential koppelt, eine Diode eingesetzt, welche den gleichen differentiellen Widerstand wie die Basis-Emitter-Strecke des Transistors des Nebenzweiges aufweist, so kompensieren sich diese beiden differentiellen Widerstände und der Übergangsbereich wird noch schmaler.

Gemäß einer vorteilhaften Ausgestaltung der erfindungsgemäßen Schaltungsanordnung mit konstantem Basispotential des Transistors im Hauptzweig ist vorgesehen, daß der Kollektorstrom des Transistors im Nebenzweig auf den Eingang einer Stromspiegelschaltung gekoppelt ist, deren Ausgangssignal auf die Basis des Transistors im Nebenzweig gekoppelt ist, wobei die Basis des Transistors mittels einer Gleichspannungsquelle gegenüber dem Bezugspotential vorgespannt ist.

Die Rückführung des Kollektorstromes des Transistors des Nebenzweiges auf dessen Basis wird hier mittels einer Stromspiegelschaltung realisiert. Bei Verwendung beispielsweise eines pnp-Transistors wird das Basispotential durch diese Rückführung erniedrigt und dadurch wiederum der Kollektorstrom erhöht. Somit wird eine Verengung des Übergangsbereiches um den Grenzwert erzielt.

Für diese Ausführungsform kann weiter eine Gleichstromquelle vorgesehen sein, die in die Stromspiegelschaltung einen Gleichstrom einspeist.

Reale Transistoren sind immer mit unvermeidlichen parasitären Kapazitäten behaftet, die bei einem einsetzenden Strom im Stromspiegel auf- bzw. umgeladen werden müssen und somit die Einsatzgeschwindigkeit des Stromspiegels herabsetzen. Um dies zu vermeiden, wird der Stromspiegel mit einem Gleichstrom aus einer Gleichstromquelle gespeist, welcher die parasitären Kapazitäten auflädt und damit die Einsatzgeschwindigkeit des Stromspiegels erhöht.

Einige Ausführungsbeispiele der Erfindung werden nachfolgend anhand der Zeichnung näher erläutert. Es zeigen:
- Fig. 1: eine erste Ausführungsform einer erfindungsgemäßen Schaltungsanordnung, bei der die Basis des Transistors des Hauptzweiges mit dem Kollektor des Transistors des Nebenzweiges gekoppelt ist und der Kollektor des Transistors des Nebenzweiges wechselstrommäßig über einen Widerstand mit dem Bezugspotential gekoppelt ist.
- Fig. 2: eine idealisierte Übertragungskennlinie der Schaltungsanordnung gemäß Fig. 1.
- Fig. 3: eine zweite Ausführungsform der Schaltungsanordnung, bei der im Unterschied zu der ersten Ausführungsform die Funktion des Widerstandes oberhalb eines vorgebbaren Amplitudengrenzwertes aufgehoben wird.
- Fig. 4: eine dritte Ausführungsform, bei der im Unterschied zu der ersten Ausführungsform der Widerstand durch eine Diode ersetzt wird.
- Fig. 5: eine vierte Ausführungsform einer erfindungsgemäßen Schaltungsanordnung, bei der Haupt- und Nebenzweig nicht miteinander gekoppelt sind.

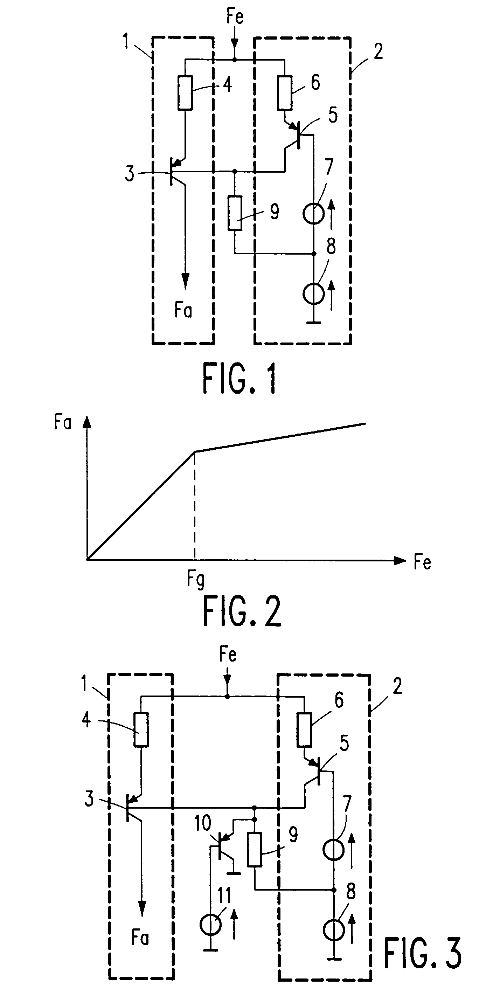

Eine in Fig. 1 dargestellte Schaltungsanordnung einer ersten Ausführungsform besteht im wesentlichen aus zwei Zweigen, einem Hauptzweig 1 und einem Nebenzweig 2. Der Hauptzweig 1 weist einen pnp-Transistor 3 auf, dessen Emitter über einen Widerstand 4 ein Eingangssignal Fₑ zugeführt wird, bei dem es sich um ein als Stromsignal vorliegendes Fernsehsignal handelt. Das Ausgangssignal Fₐ der Schaltungsanordnung wird am Kollektor des Transistors 3 abgeführt, z.B. an einen npn-Stromspiegel oder eine Gilbert-Zelle (elektronisches Potentiometer). Im Nebenzweig 2 ist ein pnp-Transistor 5 vorgesehen, dessen Emitter über einen Widerstand 6 das Eingangssignal Fₑ zugeführt wird. Die Basis des Transistors 5 ist mittels zweier in Serie geschalteter Gleichspannungsquellen 7 und 8 positiv gegenüber dem Bezugspotential vorgespannt. Ferner ist die Basis des Transistors 3 mit dem Kollektor des Transistors 5 und über einen Widerstand 9 mit dem Verbindungspunkt der Gleichspannungsquellen 7 und 8 gekoppelt. Die Spannungswerte der Gleichspannungsquellen 7 und 8 sind so ausgelegt, daß das Basispotential des Transistors 5 größer ist als das des Transistors 3. Bei kleinen Eingangsstromamplituden ist daher lediglich der Transistor 3 leitend, während der Transistor 5 gesperrt ist. Somit wird der gesamte Eingangsstrom über den Hauptzweig 1 auf den Ausgang der Schaltung geführt und das Verhältnis zwischen Ausgangsstromamplitude und Eingangsstromamplitude wird durch einen ersten Verstärkungsfaktor bestimmt, welcher in dieser Ausführungsform nahezu den Wert 1 annimmt. Mit steigendem Eingangsstrom des Signals Fₑ nimmt das Potential am Eingang der Schaltungsanordnung und damit auch am Emitter des Transistors 5 zu. Ab einem Grenzwert wird die den Transistor 5 steuernde Basis-Emitter-Spannung negativ und der Transistor 5 wird allmählich leitend. Dadurch wird ein Teil des in die Schaltungsanordnung eingespeisten Stromes auf den Nebenzweig 2 abgeleitet und Amplitudenanteile, die oberhalb des Grenzwertes liegen, werden mit einem zweiten Verstärkungsfaktor, der kleiner ist als der erste Verstärkungsfaktor, zum Ausgang der Schaltungsanordnung übertragen. In dieser Ausführungsform nimmt der zweite Verstärkungsfaktor abhängig von den Widerstandswerten der Widerstände 4, 6 und 9 Werte zwischen 0 und 1 an.

Der Übergang zwischen Verstärkungsfaktor 1 und Verstärkungsfaktor 2 erfolgt nicht schlagartig, sondern in einem Übergangsbereich um den Grenzwert. Dies ist insbesondere darin begründet, daß der differentielle Basis-Emitter-Widerstand des Transistors 5 zunächst infolge des geringen Kollektorstromes noch sehr groß ist. Um den Übergangsbereich zu verengen, ist der Widerstand 9 vorgesehen. Sobald im Nebenzweig 2 ein Kollektorstrom fließt, wird das Basispotential des Transistors 3 infolge des Stromflusses über den Widerstand 9 angehoben, wodurch der Strom im Hauptzweig 1 abnimmt, während er im Nebenzweig 2 weiter ansteigt. Der Wert des zweiten Verstärkungsfaktors ist erreicht, wenn der differentielle Basis-Emitter-Widerstand des Transistors 5 so klein ist, daß er gegenüber den Widerständen 6 und 9 vernachlässigt werden kann. Der Eingangswiderstand des Nebenzweiges 2 ergibt sich dann aus dem Wert des Widerstandes 6 abzüglich des Wertes des Widerstandes 9 und der Eingangsstrom des Signals Fₑ teilt sich entsprechend dem Verhältnis der Widerstandswerte von Widerstand 4 und der Differenz von Widerstand 6 und Widerstand 9 auf.

Bei der Dimensionierung von Widerstand 6 und Widerstand 9 ist darauf zu achten, daß der Wert des Widerstandes 6 größer ist als der Wert des Widerstandes 9, da sich andernfalls ein negativer Eingangswiderstand des Nebenzweiges einstellen würde und der gesamte Eingangsstrom auf den Nebenzweig umgeleitet wird.

Fig. 2 zeigt einen idealisierten Verlauf der Übertragungskennlinie der Schaltungsanordnung gemäß Fig. 1. Dargestellt ist der Ausgangsstrom Fₐ der Schaltungsanordnung in Abhängigkeit vom Eingangsstrom Fₑ. Unterhalb des Grenzwertes F_{g} wird der Eingangsstrom Fₑ mit dem ersten Verstärkungsfaktor verstärkt, welcher der Steigung des linken Kennlinienteils entspricht. Der gesamte Eingangsstrom Fₑ wird über den Hauptzweig 1 geführt, der Transistor 5 des Nebenzweiges 2 ist gesperrt.

Bei Eingangsströmen Fₑ, die oberhalb des Grenzwertes F_{g} liegen, wird der Anteil des Eingangsstromes unterhalb des Grenzwertes F_{g} mit dem ersten Verstärkungsfaktor und der Anteil oberhalb des Grenzwertes mit dem zweiten Verstärkungsfaktor verstärkt. Der zweite Verstärkungsfaktor entspricht der Steigung des rechten Kennlinienteils. Nun sind sowohl Transistor 3 als auch Transistor 5 leitend und der Eingangsstrom teilt sich entsprechend dem Verhältnis der Widerstandswerte von Widerstand 4 und der Differenz von Widerstand 6 und Widerstand 9 auf.

Eine in Fig. 3 dargestellte Schaltungsanordnung gemäß einer zweiten Ausführungsform ist im wesentlichen identisch mit der Schaltungsanordnung der ersten Ausführungsform gemäß Fig. 1. Die eigentliche Funktion des Widerstandes 9 der Schaltungsanordnung gemäß Fig. 1 ist es, den Übergangsbereich zwischen dem ersten und dem zweiten Verstärkungsfaktor zu verengen. Ist der Wert des zweiten Verstärkungsfaktors erreicht, ist die Funktion des Widerstandes 9 eigentlich überflüssig. Daher ist in Fig. 3 ein pnp-Transistor 10 vorgesehen, dessen Emitter mit der Basis von Transistor 3 gekoppelt ist. Der Kollektor von Transistor 10 ist mit Bezugspotential gekoppelt, die Basis des Transistors 10 ist mittels einer Gleichspannungsquelle 11 positiv gegenüber dem Bezugspotential vorgespannt. Wenn das Basispotential von Transistor 3 und damit das Emitterpotential von Transistor 10 größer als das Basispotential von Transistor 10 wird, dann wird der Transistor 10 allmählich leitend und koppelt den Kollektor von Transistor 5 mit dem Bezugspotential. Damit wird der Widerstand 9 unwirksam und der Eingangsstrom teilt sich entsprechend dem Verhältnis der Widerstandswerte von Widerstand 4 und Widerstand 6 auf.

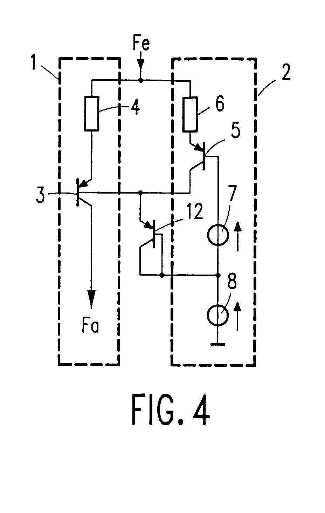

Eine in Fig. 4 dargestellte Schaltungsanordnung gemäß einer dritten Ausführungsform ist im wesentlichen identisch mit der Schaltungsanordnung der ersten Ausführungsform gemäß Fig. 1. Gegenüber dieser Schaltungsanordnung ist der Widerstand 9 durch eine Diode 12 ersetzt worden. Diese Diode 12 weist die gleiche Kennlinie wie die Basis-Emitter-Strecke des Transistors 5 auf. Somit kompensiert die Diode den differentiellen Basis-Emitter-Widerstand von Transistor 5, und der Eingangswiderstand des Nebenzweiges ist im wesentlichen gleich dem Wert des Widerstandes 6.

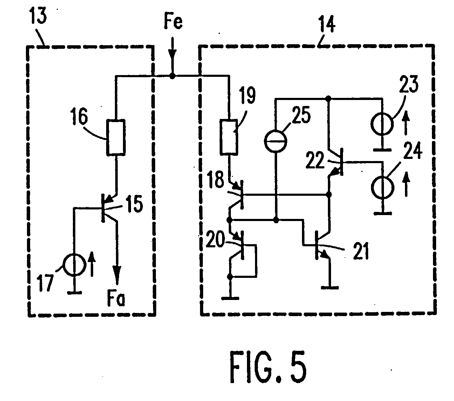

Eine in Fig. 5 dargestellte Schaltungsanordnung einer vierten Ausführungsform weist entsprechend zwei Zweige auf, einen Hauptzweig 13 und einen Nebenzweig 14, wobei diese jedoch voneinander entkoppelt sind. Im Hauptzweig 13 ist ein pnp-Transistor 15 vorgesehen, dessen Emitter das Eingangssignal über einen Widerstand 16 zugeführt wird. Die Basis des Transistors 15 ist mittels einer Gleichspannungsquelle 17 positiv gegenüber einem Bezugspotential vorgespannt. Das Ausgangssignal Fₐ der Schaltungsanordnung wird am Kollektor des Transistors 15 abgeführt. Im Nebenzweig 14 ist ein pnp-Transistor 18 angeordnet, dessen Emitter das Eingangssignal über einen Widerstand 19 zugeführt wird. Der Kollektor des Transistors 18 wird auf eine Stromspiegelschaltung gekoppelt, die einen pnp-Transistor 20 und einen npn-Transistor 21 umfaßt. Basis und Kollektor von Transistor 20 sowie der Emitter von Transistor 21 sind mit Bezugspotential gekoppelt. Ferner ist der Kollektor von Transistor 18 mit dem Emitter von Transistor 20 und der Basis von Transistor 21 sowie der Kollektor von Transistor 21 mit der Basis von Transistor 18 gekoppelt.

Ferner ist ein npn-Transistor 22 vorgesehen, dessen Emitter mit dem Kollektor von Transistor 21 gekoppelt ist. Der Kollektor des Transistors 22 ist mittels einer Gleichspannungsquelle 23 und seine Basis mittels einer Gleichspannungsquelle 24 positiv gegenüber dem Bezugspotential vorgespannt. Außerdem wird dem Stromspiegel am Emitter des Transistors 20 ein Gleichstrom aus einer Gleichstromquelle 25 zugeführt.

Bei kleinen Stromamplituden wird der gesamte Eingangsstrom des Signals Fₑ in den Hauptzweig 13 geführt. Mit zunehmendem Eingangsstrom erhöht sich das Potential am Emitter des Transistors 18 und er wird allmählich leitend. Sobald ein Kollektorstrom im Transistor 18 fließt, wird dieser über den Stromspiegel der Transistoren 20 und 21 auf die Basis des Transistors 18 zurückgekoppelt. Das Basispotential am Transistor 18 nimmt dadurch ab und dessen Kollektorstrom zu. Es handelt sich also um einen selbstverstärkenden Effekt. Der Transistor 22 hat die Aufgabe, eine Gleichspannung als Basisvorspannung auf die Basis des Transistors 18 zu koppeln.

Die Transistoren 20 und 21 des Stromspiegels sind mit unvermeidlichen parasitären Kapazitäten behaftet, die bei einem einsetzenden Strom im Stromspiegel auf- bzw. umgeladen werden müssen und dadurch die Einsatzgeschwindigkeit des Stromspiegels herabsetzen. Daher wird der Stromspiegel mit einem Gleichstrom aus einer Gleichstromquelle 25 gespeist, welche die parasitären Kapazitäten auflädt und damit die Einsatzgeschwindigkeit des Stromspiegels erhöht.

## Patentansprüche

1. Schaltungsanordnung zur amplitudenabhängigen Bedämpfung eines Fernsehsignals, welche Amplitudenwerte des Fernsehsignals unterhalb eines vorgebbaren Grenzwertes um einen ersten Verstärkungsfaktor verstärkt als Ausgangssignal liefert und welche bei Amplitudenwerten oberhalb des Grenzwertes den Amplitudenanteil unterhalb des Grenzwertes um den ersten Verstärkungsfaktor und Amplitudenanteile oberhalb des Grenzwertes um einen zweiten Verstärkungsfaktor verstärkt als Ausgangssignal liefert, wobei der zweite Verstärkungsfaktor kleiner gewählt ist als der erste,
dadurch gekennzeichnet, daß das Fernsehsignal als Stromsignal vorliegt, welches einem Haupt- (1; 13) und einem Nebenzweig (2; 14) zugeführt wird, in welchen es jeweils über einen Widerstand (4,6; 16,19) dem Emitter jeweils wenigstens eines Transistors (3,5; 15,18) zugeführt wird, daß jeweils die Basis beider Transistoren (3,5; 15,18) mittels Gleichspannungsquellen (7,8; 17,24) gegenüber einem Bezugspotential vorgespannt ist, daß der Kollektorstrom des Transistors (3; 15) im Hauptzweig (1; 13) im wesentlichen das Ausgangssignal darstellt und daß der Grenzwert mittels der Differenz der Basispotentiale beider Transistoren (3,5; 15,18) und der zweite Verstärkungsfaktor mittels des Verhältnisses der Widerstandswerte beider Widerstände (4,6; 16,19) vorgebbar ist.

2. Schaltungsanordnung nach Anspruch 1,
dadurch gekennzeichnet, daß das Basispotential des Transistors (3) im Hauptzweig (1) in Abhängigkeit des Kollektorstromes des Transistors (5) des Nebenzweiges (2) derart gesteuert wird, daß eine Erhöhung des Kollektorstromes des Transistors (5) des Nebenzweiges (2) das Basispotential des Transistors (3) des Hauptzweiges (1) derart ändert, daß der Kollektorstrom des Transistors (3) des Hauptzweiges (1) vermindert wird.

3. Schaltungsanordnung nach Anspruch 1,
dadurch gekennzeichnet, daß das Basispotential des Transistors (15) im Hauptzweig (13) konstant gehalten wird und daß das Basispotential des Transistors (18) im Nebenzweig (14) bei Erhöhung des Kollektorstromes des Transistors (18) im Nebenzweig (14) derart verändert wird, daß dessen Kollektorstrom infolge der Basispotentialänderung weiter erhöht wird.

4. Schaltungsanordnung nach Anspruch 2,
dadurch gekennzeichnet, daß die Basis des Transistors (3) des Hauptzweiges (1) mit dem Kollektor des Transistors (5) des Nebenzweiges (2) gekoppelt ist und daß der Kollektor des Transistors (5) des Nebenzweiges (2) wechselstrommäßig über einen Widerstand (9) mit dem Bezugspotential gekoppelt ist.

5. Schaltungsanordnung nach Anspruch 4,
dadurch gekennzeichnet, daß der Kollektor des Transistors (5) des Nebenzweiges (2) mit dem Emitter eines dritten Transistors (10) gekoppelt ist, dessen Kollektor mit Bezugspotential gekoppelt ist und daß die Basis des Transistors (10) gegenüber dem Bezugspotential vorgespannt ist.

6. Schaltungsanordnung nach Anspruch 2,
dadurch gekennzeichnet, daß die Basis des Transistors (3) des Hauptzweiges (1) mit dem Kollektor des Transistors (5) des Nebenzweiges (2) gekoppelt ist und daß der Kollektor des Transistors (5) des Nebenzweiges (2) wechselstrommäßig über eine Diode (12) mit dem Bezugspotential gekoppelt ist.

7. Schaltungsanordnung nach Anspruch 3,
dadurch gekennzeichnet, daß der Kollektorstrom des Transistors (18) im Nebenzweig (14) auf den Eingang einer Stromspiegelschaltung gekoppelt ist, deren Ausgangssignal auf die Basis des Transistors (18) im Nebenzweig (14) gekoppelt ist, wobei die Basis des Transistors (18) mittels einer Gleichspannungsquelle (24) gegenüber dem Bezugspotential vorgespannt ist.

8. Schaltungsanordnung nach Anspruch 7,
dadurch gekennzeichnet, daß die Stromspiegelschaltung einen vierten (20) und einen fünften Transistor (21) aufweist, wobei die Basis des vierten Transistors (20) und dessen Kollektor mit dem Bezugspotential und der Emitter des vierten (20) und die Basis des fünften Transistors (21) mit dem Kollektor des Transistors (18) im Nebenzweig (14) gekoppelt sind, und wobei der Emitter des fünften Transistors (21) mit dem Bezugspotential und dessen Kollektor mit der Basis des Transistors (18) des Nebenzweiges (14) gekoppelt ist.

9. Schaltungsanordnung nach Anspruch 7 oder 8,
dadurch gekennzeichnet, daß eine Gleichstromquelle (25) vorgesehen ist, die in die Stromspiegelschaltung einen Gleichstrom einspeist.

## Claims

1. A circuit arrangement for amplitude-dependent attenuation of a television signal, which arrangement supplies amplitude values of the television signal below a predeterminable limit value as an output signal amplified by a first gain factor, and, at amplitude values above the limit value, supplies the part of the amplitude below the limit value as an output signal amplified by the first gain factor and parts of the amplitude above the limit value as an output signal amplified by a second gain factor, the second gain factor being chosen to be smaller than the first gain factor, characterized in that the television signal is a current signal which is applied to a main branch (1; 13) and a sub-branch (2; 14) in which said signal is applied to the emitter of at least one transistor (3,5; 15,18) via a resistor (4,6; 16,19), in that the base of each transistor (3,5; 15,18) is biased with respect to a reference potential by means of DC sources (7,8; 17,24), in that the collector current of the transistor (3; 15) in the main branch (1; 13) essentially represents the output signal, and in that the limit value is predeterminable by means of the difference between the base potentials of the two transistors (3,5; 15,18) and the second gain factor is predeterminable by means of the resistance ratio between the two resistors (4,6; 16,19).

2. A circuit arrangement as claimed in claim 1, characterized in that the base potential of the transistor (3) in the main branch (1) is controlled in dependence upon the collector current of the transistor (5) in the sub-branch (2) in such a way that an increase of the collector current of the transistor (5) in the sub-branch (2) changes the base potential of the transistor (3) in the main branch (1) in such a way that the collector current of the transistor (3) in the main branch (1) is decreased.

3. A circuit arrangement as claimed in claim 1, characterized in that the base potential of the transistor (15) in the main branch (13) is maintained constant, and in that, upon an increase of the collector current of the transistor (18) in the sub-branch (14), the base potential of the transistor (18) in the sub-branch (14) is changed in such a way that its collector current is further increased in response to the change of the base potential.

4. A circuit arrangement as claimed in claim 2, characterized in that the base of the transistor (3) in the main branch (I) is coupled to the collector of the transistor (5) in the sub-branch (2), and in that the collector of the transistor (5) in the sub-branch (2) is coupled for alternating current to the reference potential via a resistor (9).

5. A circuit arrangement as claimed in claim 4, characterized in that the collector of the transistor (5) in the sub-branch (2) is coupled to the emitter of a third transistor (10) whose collector is coupled to the reference potential, and in that the base of the transistor (10) is biased with respect to the reference potential.

6. A circuit arrangement as claimed in claim 2, characterized in that the base of the transistor (3) in the main branch (1) is coupled to the collector of the transistor (5) in the sub-branch (2), and in that the collector of the transistor (5) in the sub-branch (2) is coupled for alternating current to the reference potential via a diode (12).

7. A circuit arrangement as claimed in claim 3, characterized in that the collector current of the transistor (18) in the sub-branch (14) is coupled to the input of a current mirror circuit whose output signal is coupled to the base of the transistor (18) in the sub-branch (14), said base of the transistor (18) being biased with respect to the reference potential by means of a DC source (24).

8. A circuit arrangement as claimed in claim 7, characterized in that the current mirror circuit has a fourth transistor (20) and a fifth transistor (21), in which the base of the fourth transistor (20) and its collector are coupled to the reference potential, and the emitter of the fourth transistor (20) and the base of the fifth transistor (21) are coupled to the collector of the transistor (18) in the sub-branch (14), and in which the emitter of the fifth transistor (21) is coupled to the reference potential, and its collector is coupled to the base of the transistor (18) in the sub-branch (14).

9. A circuit arrangement as claimed in claim 7 or 8, characterized in that a DC source (25) is provided, which supplies a direct current to the current mirror circuit.

## Revendications

1. Circuit d'atténuation en fonction de l'amplitude d'un signal de télévision qui délivre comme signal de sortie des valeurs d'amplitude du signal de télévision en dessous d'une valeur seuil à déterminer préalablement, amplifiées d'un premier facteur d'amplification et qui délivre en cas de valeurs d'amplitude supérieures à la valeur limite la partie de l'amplitude inférieure à la valeur limite amplifiée du premier facteur d'amplification et la partie de l'amplitude au-delà de la valeur limite amplifiée d'un deuxième facteur d'amplification comme signal de sortie, le deuxième facteur d'amplification étant inférieur au premier,
caractérisé en ce que le signal de télévision est présent sous la forme d'un signal de courant qui est amené à une branche principale (1,13) et à une branche accessoire (2.,14) dans lesquelles il est respectivement amené par l'intermédiaire d'une résistance (4,6 ; 16,19) à l'émetteur d'au moins un transistor (3,5 ; 15,18), que la base des deux transistors (3,5 ; 15,18) est respectivement polarisée à l'aide de sources de tension continue (7,8 ; 17,24) par rapport à un potentiel de référence, que le courant de collecteur du transistor (3 ; 15) dans la branche principale (1,13) représente essentiellement le signal de sortie et que la valeur limite peut être déterminée préalablement à l'aide de la différence des potentiels de base des deux transistors (3, 5; 15,18) et le deuxième facteur d'amplification à l'aide de la proportion des valeurs de résistance des deux résistances (4,6 ; 16,19).

2. Circuit selon la revendication 1,
caractérisé en ce que le potentiel de base du transistor (3) dans la branche principale (1) est commandé en fonction du courant de collecteur du transistor (5) de la branche accessoire (2) de telle sorte qu'une augmentation du courant du collecteur du transistor (5) de la branche accessoire (2) fasse varier le potentiel de base du transistor (3) de la branche principale (1) de telle sorte que le courant du collecteur du transistor (3) de la branche principale (1) soit réduit.

3. Circuit selon la revendication 1,
caractérisé en ce que le potentiel de base du transistor (13) dans la branche principale (15) est maintenu constant et que le potentiel de base du transistor (18) dans la branche accessoire (14) est modifié en cas d'augmentation du courant du collecteur du transistor (18) dans la branche accessoire (14) de telle sorte que son courant de collecteur soit encore augmenté en raison de la variation du potentiel de base.

4. Circuit selon la revendication 2,
caractérisé en ce que la base du transistor (3) de la branche principale (1) est couplée au collecteur du transistor (5) de la branche accessoire (2) et que le collecteur du transistor (5) de la branche accessoire (2) est couplé en courant alternatif par l'intermédiaire d'une résistance (9) au potentiel de référence.

5. Circuit selon la revendication 4,
caractérisé en ce que le collecteur du transistor (5) de la branche accessoire (2) est couplé à l'émetteur d'un troisième transistor (10) dont le collecteur est couplé au potentiel de référence et que la base du transistor (10) est polarisée par rapport au potentiel de référence.

6. Circuit selon la revendication 2,
caractérisé en ce que la base du transistor (3) de la branche principale (1) est couplée au collecteur du transistor (5) de la branche accessoire (2) et que le collecteur du transistor (5) de la branche accessoire (2) est couplé en courant alternatif par l'intermédiaire d'une diode (12) avec le potentiel de référence.

7. Circuit selon la revendication 3,
caractérisé en ce que le courant de collecteur du transistor (18) dans la branche accessoire (14) est couplé à l'entrée d'un circuit de miroir de courant dont le signal de sortie est couplé sur la base du transistor (18) dans la branche accessoire (14), la base du transistor (18) étant polarisée à l'aide d'une source de tension continue (24) par rapport au potentiel de référence.

8. Circuit selon la revendication 7,
caractérisé en ce que le circuit de miroir de courant présente un quatrième (20) et un cinquième (21) transistors, la base du quatrième transistor (20) et son collecteur étant couplés avec le potentiel de référence et l'émetteur du quatrième (20) et la base du cinquième transistor (21) au collecteur du transistor (18) dans la branche accessoire (14) et l'émetteur du cinquième transistor (21) étant couplé au potentiel de référence et son collecteur avec la base du transistor (18) de la branche accessoire (14).

9. Circuit selon l'une des revendications 7 ou 8,
caractérisé en ce qu'il est prévu une source de courant continu (25) qui alimente un courant continu dans le circuit de miroir de courant.
